# EUROPEAN PATENT APPLICATION

(11) **EP 0 964 305 A1**
(43) Date of publication of application: **15.12.1999**
(21) Application number: 98401369.8
(22) Date of filing: 08.06.1998
(51) Int. Cl.: G03F 7/00, G03F 7/20, G02B 6/12

(54) **Method of making a photonic crystal**

(71) Applicant: CORNING INCORPORATED, Corning, N.Y. 14831 (US)
(72) Inventor: Cotteverte, Jean-Charles, Corning, NY 14831 (US); Dahmani, Brahim, Corning, NY 14831 (US); Renvaze, Christophe, Corning, NY 14831 (US)
(74) Representative: Boon, Graham Anthony

(57) **Abstract**

Disclosed is a method of making a photonic crystal having a period suitable for use with light wavelengths in the range of about 800 nm to 1800 nm. The method includes the use of a thick photoresist on a substrate in which the photoresist is exposed to interference fringes formed from four non-coplanar laser beams. A masking technique, which makes use of backside illumination of the photoresist, is described in a method of making a photonic crystal which is a passive optical component. The types of passive optical components which can be made include a waveguide, a light cavity, as well as couplers, splitters, and wavelength division multiplexers.

## Description

### Background of the Invention

The invention relates to a method of making photonic crystal passive optical devices. In particular, the photonic crystal devices are suitable for use in optical telecommunication systems which operate in the range from about 800 nm to 1800 nm. A preferred operating wavelength range is 1300 nm to 1600 nm.

A photonic crystal is a structure having a periodic variation in dielectric constant. The periodic structure may be 1, 2 or 3 dimensional. The photonic crystal allows passage of certain light wavelengths and prevents passage of other light wavelengths. Thus the photonic crystals are said to have allowed bands of wavelengths and band gaps which define the wavelengths which are excluded from the crystal. That is, light having a wavelength in the band gap may not pass through the photonic crystal. Light having a wavelength in bands above and below the band gap may propagate through the crystal. A photonic crystal exhibits a set of band gaps which are analogous to the solutions of the Bragg scattering equation. The band gaps are determined by the period of the variation in dielectric constant. Thus the periodic array of variation in dielectric constant acts as a Bragg scatterer of light of certain wavelengths in analogy with the Bragg scattering of x-rays by atoms in a lattice.

Introducing defects into the periodic variation of the photonic crystal dielectric constant, will introduce the so-called defect modes, corresponding to particular light wavelengths which can propagate in the portion of the crystal containing the defect. Because a particular wavelength cannot propagate in the normal portion of the crystal but can propagate in the defect region, a point defect within the crystal can serve to trap the particular light wavelength in a localized "light cavity". Analogously, a line defect in the photonic crystal can act as a waveguide, allowing a guided mode to exist in the band gap, the crystal lattice serving to confine the guided light to the defect line in the crystal. In a three dimensional photonic crystal, a plane defect would behave as a slab waveguide for wavelengths within the band gap.

A review of the structure and function of photonic crystals is found in, "Photonic Crystals: putting a new twist on light", Nature, vol. 386, March 13, 1997, pp. 143-149, Joannopoulos et al.

For the particular wavelengths of interest in telecommunications, i.e., those in the range of about 1300 nm to 1600 nm, as set forth above, the period of the dielectric constant variation must be about 500 nm. Techniques which are effective to provide this small periodicity include electron beam, X-ray lithography, or laser interference lithography such as is set forth in U.S. patent 5,142,385, Anderson et al. Recent progress in photolithography, for example that using an excimer laser, can achieve resolution of about 0.18 Tm.

In this last document, a feedback loop between a phase sensor arrangement and a phase shifting element is used to stabilize the laser intensity pattern in space and time. The relative phase of coherent laser beams are measured and adjusted by a phase shifter placed in the path of one of the beams. Measurement of the relative phase of the beams is difficult in that it involves directing a sample of each beam onto a common plane where the beams interact to form an interference pattern. The phase shifter is adjusted to minimize change in this interference pattern, thereby stabilizing the relative phase of the main beams.

### Summary of the Invention

The method of the present invention makes use of at least two distinct interference patterns to write a photonic crystal lattice in a photoresist layer. The photoresist is exposed using laser lithography in which crossed interference patterns are written on the resist. A novel backside exposure process enables the writing of a waveguide within a photonic crystal in which the effective gap between the photoresist and the mask is truly zero.

A first aspect of the invention is a method of making a photonic crystal by first coating a flat substrate with a thick photoresist layer. In the context of this application, thick means in the range of 3 Tm to 10 Tm. A laser interference fringe pattern is then formed on the surface of the photoresist. The fringe pattern penetrates the thickness of the photoresist to provide full thickness exposure of the photoresist. The intensity and duration of exposure of the photoresist to this fringe pattern are pre-selected to deliver an exposure which is below the exposure threshold of the photoresist material. Photoresist material exposed to light at a level below threshold level will not be affected in the development step.

The photoresist is exposed to a second set of laser interference fringes. The long dimension of this second set of fringes is oriented at an angle relative to the long dimension of the first set of fringes. Again the exposure is chosen to be less than the exposure threshold of the photoresist. However, the photoresist areas which are exposed to both the first and second set of fringes, i.e., the areas in which the fringe patterns overlap, do receive an exposure above threshold.

One skilled in the art will readily see that more than two sets of fringes, having respective pre-selected length, width, and intensity and being incident on the photoresist for respective pre-selected time periods, can be used to expose, to a level above threshold, portions of photoresist which form a variety of patterns having a wide range of periodicity. For example, a three-fringe pattern exposure scheme can be used to obtain a hexagonal photonic crystal pattern. In this case, the respective axes of the fringe patterns, i.e., a line passing through the long dimension of the fringes at right angles to the long dimension of the fringes, are rotated 120° relative to each other.

In the final step of the novel method, the exposed photoresist is developed to form the photonic crystal. Development means that a chemical is applied to the photoresist to dissolve those portions of the photoresist which have received an exposure above the threshold level. The periodic structure which remains after development is a photonic crystal. The aspect ratio of the periodically arrayed features of the of the photonic crystal, i.e., the ratio of feature height to feature diameter, must be greater than or equal to about 3 in order for the photonic crystal to operate in the infrared wavelength region and serve to contain a propagation or standing mode of the infrared light. The feature periodicity must be in the range of Σ/3, where Σ is the signal light wavelength, if the first band gap of the photonic crystal is to be used. The feature periodicity is larger in cases where the higher order band gaps are used.

The photoresist layer may be applied to the substrate using any of several techniques known in the art including, spinning, dip coating and dry plasma coating.

The difference in dielectric constant between the materials making up the periodic array of features is preferably at least a factor of 4. A difference of a factor of 10 is feasible. In general the size of the photonic band gap increases as the disparity increases in the respective dielectric constant of the materials making up the photonic crystal.

In an embodiment of the method, two essentially identical interference patterns are crossed to expose the photoresist to a periodic pattern of light intensity above the photoresist threshold. The fringe width and fringe spacing of the interference patterns are selected to provide a lattice array having a period in the range of about 0.3 to 0.9 times the signal wavelengths which will interact with the photonic crystal. In an example of this embodiment, the photoresist material is the light conducting portion of the crystal and so is selected to be transparent to the selected band of signal light wavelengths. The wavelength band in the range of about 1300 nm to 1600 nm includes the signal range of most telecommunications systems currently planned or in operation.

The photonic crystal lattice features may be arranged in any of a number of patterns including a square, i.e., each feature being equidistant from its nearest neighbor, a face centered cubic pattern, or a hexagonal pattern, as noted above. That is, a lattice having an appropriate feature period, which may be called the feature pitch, may have essentially any periodic feature arrangement and still have photonic crystal properties.

A square lattice may be written in the photoresist by choosing an included angle of 90° between the fringe pattern axes. In writing any lattice identical results are achieved by directing the fringe patterns onto the photoresist either sequentially or simultaneously.

The invention includes photonic crystals made using the method and embodiments thereof described above. A three dimensional photonic crystal can be constructed by forming a vertical stack of planar photonic crystals made by the method and embodiments described above. To provide a functional 3-D photonic crystal, a particular alignment is required for each member of the stack. See, for example, Noda, et al., Jpn J. Appl. Phys. 35 (1996) 909.

A second aspect of the invention is a method of making a passive optical component by depositing a thin layer of material on a flat substrate. By thin is meant a layer which is less than or equal to about 1 Tm. The thin layer is comprised of a material that is opaque to light having a wavelength in the range of the pre-selected wavelengths, i.e., the photoresist exposure wavelengths. A thin photoresist layer is applied over the first thin layer. The material of the substrate is chosen to be transparent to the pre-selected band of wavelengths.

A particular pattern of material opaque to the pre-selected wavelengths is formed on the substrate using a mask including the particular shape. After irradiation and development of the thin photoresist, a dual layer, thin photoresist over thin first layer, in the shape of the particular pattern remains on the substrate. The remainder of the substrate is covered only by the thin first layer. The remaining portion of the photoresist layer protects the underlying first thin layer, while the unprotected thin layer is removed by any one of several known methods, for example plasma etching. The thin photoresist layer is then removed leaving behind the first thin layer in the shape of the particular pattern.

A thick photoresist layer is then applied over the substrate and the first layer shape. The thick photoresist layer is exposed to light having a wavelength in the pre-selected band of wavelengths. The light is directed through the substrate onto the backside of the photoresist layer. In this way, the patterned thin first layer, which is opaque to the incident light, prevents light from reaching that portion of the thick photoresist layer that covers the patterned thin first layer. After irradiation and development are completed, a thick photoresist layer on the first thin layer pattern remains on the substrate. The pattern or shape of the thin first layer and the covering photoresist layer is chosen to be that of a light guiding structure. It is noteworthy that the photoresist material has unique properties in that it must act as a waveguide as well as a photoresist. Thus the material must have a high refractive index, be an absorber of the ultraviolet activating or recording light, and transparent to the infrared signal light.

As in the first aspect of the invention, the irradiation of the photoresist is in the form of two or more crossing interference fringe patterns. The total radiation received by the photoresist is above threshold only for those portions of the photoresist which receive radiation from more than one fringe pattern. A laser interferometer is used to form the interference fringes and direct the fringes onto either the top or bottom surfaces of the photoresist. The bottom surface is the surface in contact with the substrate. The top surface is opposite and substantially parallel to the bottom surface.

Once the backside irradiation is complete, the thick photoresist is developed, leaving behind on the substrate a periodic array of cylindrical holes (or posts, in an alternative embodiment) in the photoresist. A thick layer of photoresist remains over the shaped first thin layer which is opaque to the wavelength of light used to irradiate the thick photoresist. The resulting structure is a photonic crystal in which contains a waveguide cavity or through which a waveguide path passes.

The terms thick and thin retain the same meaning as given above. The means of applying the photoresist materials and the relative dielectric constant of the photoresist and the material, if any, filling the holes are also as stated above.

The plan view cross section of the opaque portion of the mask, i.e., the shape of the opaque portion when viewed from directly above, which produces an essentially identically shaped first thin opaque layer on the substrate, may be that of any of several light guiding structures. For example the light guiding structure could be a waveguide path which passes through the photonic crystal. The path may incorporate one or more turns or bends. Multiple paths can be made through the photonic crystal, the paths arranged in the shape of optical splitters or couplers, known in the planar waveguide art. A splitter or coupler is often described in terms of the number N of input ports and the number M of output ports, where N and M are integers ≥ 1. Thus for example a 1 x 4 coupler has one light input port and four light output ports.

A typical single mode waveguide path width in is the range of 0.7 Tm to 20 Tm, where the width is the shortest distance between the first and second sides of periodic features bounding the waveguide path.

To form a light trap or cavity in the photonic crystal, the opaque mask may be used to form a defect, i.e., a difference in the periodicity of the periodic array of holes (posts) of the photonic crystal. One embodiment of the mask for introducing such a defect includes an opaque mask portion having an elongated shape. The elongated opaque portion has at least one generally circular opening. The width of the elongated mask portion is greater than one hole (post) diameter but less than two hole (post) diameters. The entire elongated mask portion lies within the photonic crystal. Stated differently, the thick photoresist layer, which results from application of the mask and carrying out the remaining process steps, is bounded on all sides by the photonic crystal lattice. The long dimension of the elongated mask is oriented along a row of holes (posts). Then a light wavelength for which the photonic crystal is transparent may be propagated into the crystal. The dimensions of the defect, i.e. the elongated photoresist portion having a circular opening, constitute a periodic lattice for which the wavelength of the propagating light is in the band gap. The propagating light is effectively trapped at the defect site.

Thus the photonic crystal may be configured to have defects which trap a number of wavelengths which are in the band gap wavelength range of the photonic crystal.

The method allows one to design and fabricate combinations of waveguide paths and traps or cavities that act as passive optical components, for coupling, splitting, filtering, and multiplexing. Stacking the passive components made using the novel method results in three-dimensional photonic crystal structures.

### Brief Description of the Drawings

Fig. 1 is a chart of frequency vs. wave vector for a photonic crystal showing the first three regions or bands of frequencies which may not propagate in the crystal.
Figs. 2a and 2b are examples of two-dimensional photonic crystals showing a periodic array of cylindrical openings and a periodic array of cylindrical posts respectively.
Fig. 3 is an illustration of a waveguide path through a photonic crystal.
Figs. 4a, 4b, 4c, and 4d illustrate the superposition of interference fringes on a photoresist to fabricate a photonic crystal.
Figs. 5a, 5b, 5c, 5d, 5e, 5f, 5g, 5h, and 5i illustrate the series of photolithography steps which produce a waveguide path in a photonic crystal using a back exposure technique in the final step.
Fig. 6 is a schematic of a laser interferometer.
Fig. 7 shows a lithographic mask which serves to embed a defect site into a photonic crystal.
Fig. 8 is a microphotograph of a photonic crystal made using applicant's novel method.

### Detailed Description of the Invention

The periodic lattice of features, having a spacing of the order of the wavelength of light with which the lattice will interact, is called a photonic crystal because the lattice behaves much like the atomic lattice of a crystal which reflects x-ray wavelengths. The features of the photonic lattice, i.e., the holes or pillar-like structures, are sometimes referred to as "atoms".

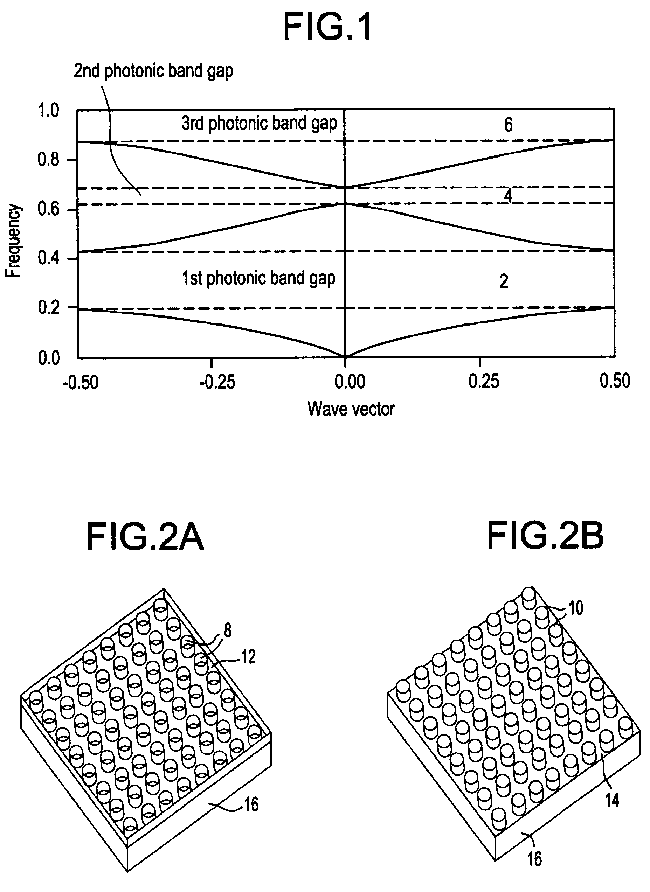

The property of the photonic crystal that makes the crystal so versatile in forming passive optical devices is the presence of wavelength band gaps. The crystal will transmit a first range of wavelengths and reflect a second range of wavelengths even though the two ranges are separated only by several nanometers. The band of wavelengths for which the crystal is essentially opaque is called a band gap. A photonic crystal has a band gap corresponding to the orders of reflection of incident light. The chart of light frequency versus light wave vector of Fig.1, shows the allowed frequencies, i.e., those transmitted by the crystal, as well as the first, second, and third band gaps, 2, 4, and 6 respectively. Note that the "order of the band gap increases with increasing frequency. If one wishes to have a wavelength Σ in the first order band gap, the feature period must be of the order of Σ/3.

A more detailed discussion of photonic crystal structure and properties is found in, Photonic Crystals. Joannopoulos et al., Princeton University Press, Princeton NJ, 1995.

Examples of photonic crystals, which provide band gaps analogous to those shown in Fig. 1, are illustrated in Figs. 2a and 2b. The periodic features are hole-like openings 8 in Fig. 2a and are cylindrical pegs 10 in Fig. 2b. The two embodiments have essentially identical function provided the feature period and contrast in dielectric constant between the feature and its immediate environment, 12 and 14 respectively in Fig. 2a and 2b, are identical. Both photonic crystal types are shown supported by a flat surface of substrate 16.

The height of the pegs 10 or the corresponding depth of the holes 8 must be of the order of 3 Tm to 4Tm to propagate a single mode in the wavelength range 1300 nm to 1600 nm, or in the wider range, 800 nm to 1800 nm, of usefulness of the waveguide. The feature, pegs or holes or other structure, periodicity is of the order 0.5 Tm. A preferred feature aspect ratio is ≥ 10 which means the diameter or width of the feature is about 0.2 Tm to 0.3 Tm. These very small dimensional requirements make the construction of a photonic crystal difficult.

Yet, as will be seen below, feasibility has been demonstrated with the method herein disclosed. The inventors contemplate that improvements in the stability of the interferometer relative to the substrate will allow the novel method to provide photonic crystals which may be used in the first band gap.

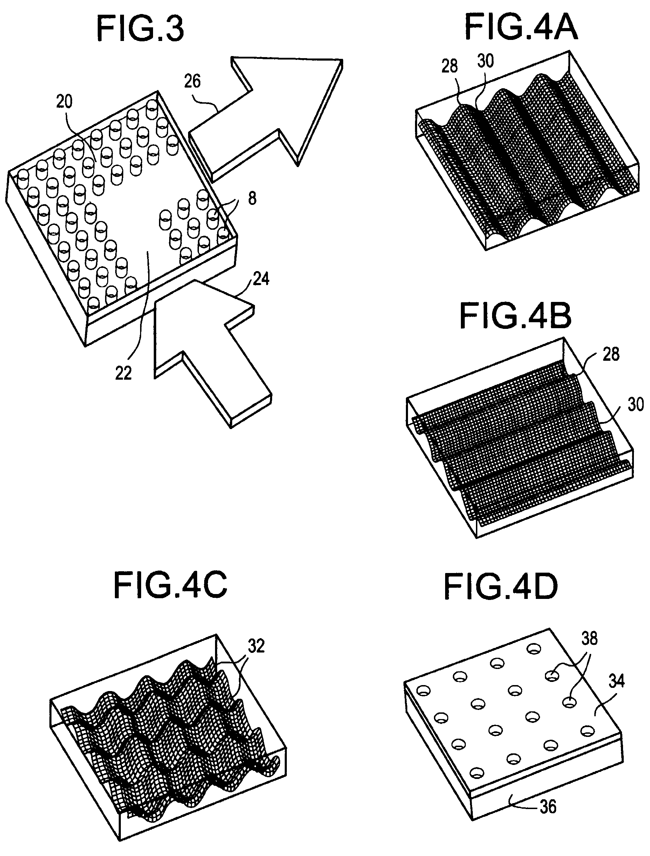

In Fig. 3 is illustrated a photonic crystal 20 having an embedded waveguide path 22. Arrows 24 and 26 show a possible direction of light propagation through the crystal. The periodicity of holes 8 is selected to reflect the band of wavelengths launched into waveguide path 22. A right angle bend is used in the illustrated waveguide path of Fig. 3 to emphasis an unusual and useful property of the photonic crystal waveguide. Because light may only enter and exit via the openings marked by arrows 26 and 24, the crystal guides the light around a sham bend without appreciable loss. The light lost is that which escapes through the launch port due to 180° back reflection.

The novel principle used in the method is illustrated in Figs. 4a - 4d. In Fig. 4a is shown a first interference pattern having intensity maxima 28 and minima 30. This pattern, commonly called an interference fringe pattern, is directed onto a photoresist, 34 in Fig. 4d, which coats a flat surface of a substrate, 36 in Fig. 4d. The intensity of the pattern and the time of exposure of the photoresist to the pattern are selected such that the photoresist does not receive an exposure above its threshold. A second interference fringe pattern, shown in Fig. 4b having respective maxima and minima 28 and 30 respectively, is substantially identical to the fringe pattern of Fig. 4a except that the patterns are rotated 90° relative to one another. As before, the intensity and duration of exposure is selected to be below the photoresist threshold. However, the sum of the exposures due to the fringe patterns of Fig. 4a and 4b is above the photoresist threshold. The sum of the exposures due to the two interference fringe patterns is given in Fig. 4c showing areas 32 which receive light from both interference patterns. It is these areas, 32, where the two interference fringe patterns are superposed one upon the other. When the exposed photoresist is developed, holes 38 appear at areas 32. A photoresist sensitive to ultraviolet light, for example at 460 nm, could be imprinted with holes having a period as small as 230 nm. The depth of focus of the fringe pattern is far greater than the thickness of the photoresist. Thus a thick photoresist, for example one having a thickness of 3 Tm to 10 Tm, can be properly exposed.

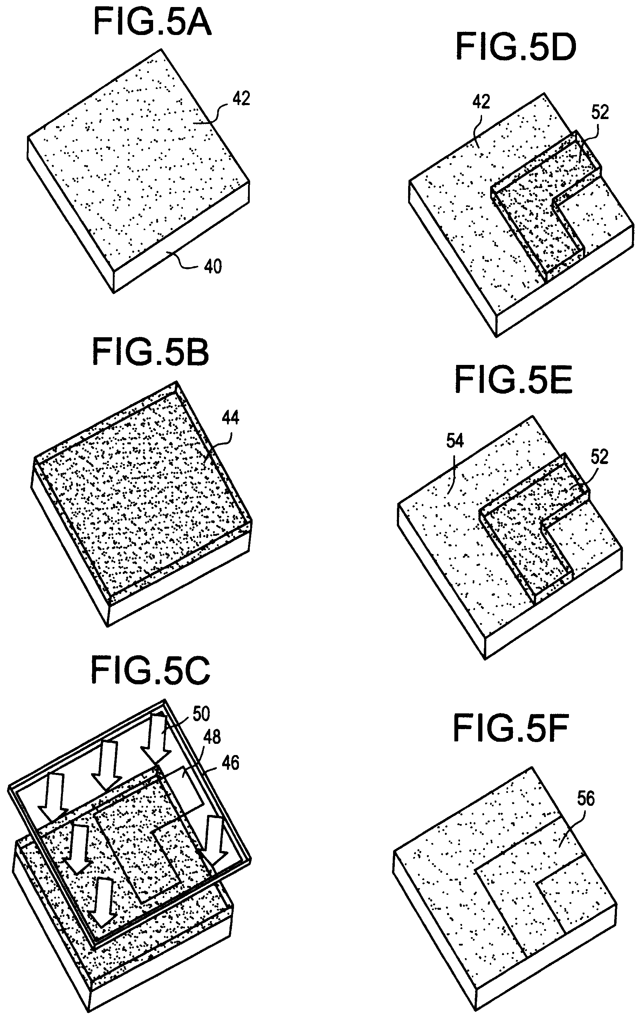

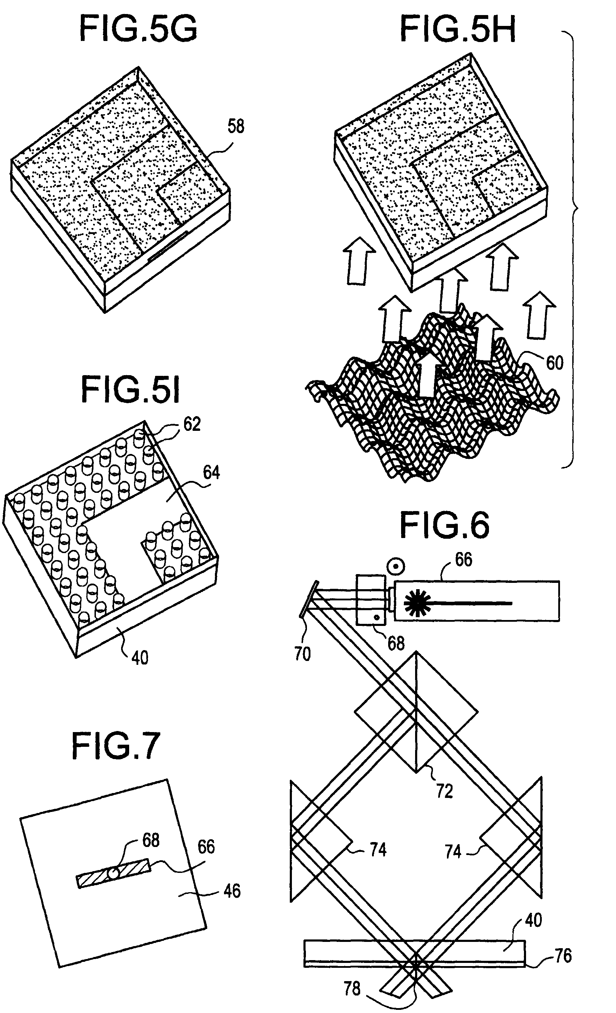

The Figs. 5a - 5i illustrate the steps in forming a passive optical component in a photonic crystal using the novel method together with a back exposure technique which provides for zero spacing between mask and substrate. In Fig. 5a is shown a substrate 40 coated with a thin layer of material which is opaque to the light wavelength which will be used to expose the photoresist. A thin photoresist layer 44 in Fig. 5b is applied over the thin opaque layer. Mask 46 in Fig. 5c, having a portion 48 opaque to the photoresist light exposure wavelength, is placed over the thin photoresist layer 44 as indicated by arrows 50. The photoresist is developed to produce the structure shown in Fig. 5d. in which the thin opaque layer 42 is exposed except for portion 52 which is coated with the photoresist which was protected by mask portion 48. The first thin opaque layer 42 is etched away to produce the bare substrate surface 54 and the protected photoresist portion 52. The photoresist is then removed leaving a thin opaque layer portion on the substrate, shown as portion 56 in Fig. 5f, in the shape of the opaque portion of the mask 48. A thick photoresist layer, 58 in Fig. 5g, is applied over the substrate and the thin opaque layer portion.

An intersecting pattern of interference fringes, 60 in Fig. 5h, is directed through the substrate onto the backside of the photoresist. The substrate must of course be selected to be at least partially transparent to the exposure light wavelength. The conditions on the intensity and duration of exposure of the photoresist are as stated above in conjunction with the description of the process illustrated in Figs. 4a - 4d. Note that the thin opaque layer portion 56 is a zero gap mask for the backside, i.e., the side in contact with the substrate and the thin opaque layer, of the thick photoresist. After development of the exposed photoresist there remains on the substrate 40 in Fig. 5i a photonic crystal lattice of cylindrical holes 62 and an undeveloped portion of photoresist, 64, having the shape of the thin opaque layer portion 56.

An alternative mask configuration can be used in the step illustrated in Fig. 5c. To imprint a defect site in the photonic crystal which will trap a particular light wavelength at the defect site, a mask 46 having an elongated opaque portion 66 which includes a transparent portion 68 as shown in Fig. 7 may be used. The defect site must have an appropriate size to support a mode, i.e., to act as a resonant cavity.

The laser interferometer used to expose the photoresist is known. An example of a simple and stable interferometer for directing fringes onto the backside of a photoresist, through the substrate is illustrated in Fig. 6. Ultraviolet light from Laser 66 is passed through filter 68, striking mirror 70. The coherent laser light proceeds to beam splitter 72 from which the light is directed through mirrored prisms 74. The two light beams pass through substrate 40 and produce a set of interference fringes where the beams recombine at 78 on the backside of the photoresist. The depth of focus of the fringes is such that the full thickness of the photoresist is exposed.

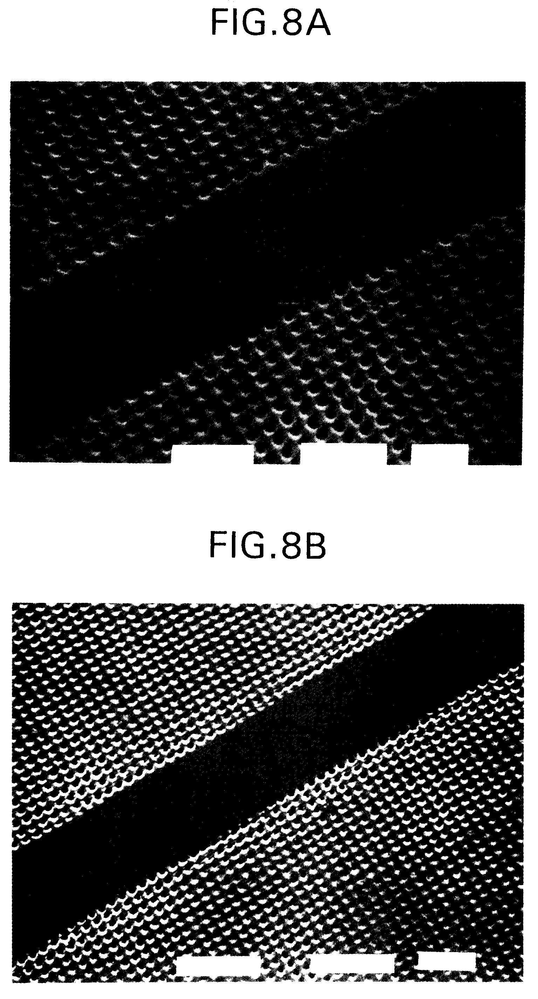

A photograph of a photonic crystal made using the method described hereinabove is shown in Fig. 8. The hole diameter is on the order of 0.5 Tm and the waveguide path through the photonic crystal is about 8Tm in width. The upper half of the photograph of Fig. 8 was taken at about double the magnification of the lower half.

### Example

A square substrate having side dimensions 75 mm and a thickness of 3 mm was coated with a 0.3 Tm silicon layer. The silicon was vapor deposited using an electron beam directed onto silicon metal. The substrate was then plasma cleaned using oxygen in a Plasmafab 505 barrel asher made by Electrotech, a United Kingdom based company. The substrate was vapor coated with HMDS primer (hexamethyldisilazane), available from the Shipley Company, for adhesive priming, and spin coated at 4200 rpm with a 1 Tm layer of Shipley S1813 photoresist. Solvents were removed from the photoresist by baking at 90 °C for 30 minutes.

Exposure was made with a chromium mask in place over the photoresist. The mask had several fine lines in the range of about 4 Tm to 10 Tm in width. After the photoresist was developed using Shipley Microposit 351 Developer and then baked at 120 °C for 30 minutes.

The silicon was then etched away using a Nextral, a company based in France, RIE plasma etcher. The etchant gas was 15 sccm SF₆ at a 30 Watt power setting and 7 millitorr pressure setting. The thin photoresist layer was removed using Shipley Remover and the substrate was again cleaned in an oxygen plasma using the Plasmafab 505 recited above. The substrate was again primed using HMDS vapor coating and then spin coated at 4500 rpm with about 6 Tm of AZ4562 photoresist available from the Hoechst Company. The substrate was then baked at 90 °C for thirty minutes. The photoresist was then irradiated from the backside using the interferometer arrangement shown in Fig. 6. The argon ion laser operated at 458 nm. The photoresist was developed using the Hoechst AZ351B developer.

The resulting photonic crystal containing a waveguide path was characterized using a Zygo Scanning interferential microscope, an Olympus BH-2 optical microscope, a Dektak 8000 profilometer, and an ABT-55 MEB, available from Akashi Beam Technology Corporation, Shinjuku NS Bldg. (P.O. Box 6131), 2-4-1, Tokyo, 163 Japan.

The SEM photograph of Fig. 8 shows feasibility of the method. Further work is required to refine the thick photoresist exposure and processing techniques.

It will be understood by those skilled in the art that the invention described herein includes those embodiments not expressly described but which use the principles of the invention. For example one could use a negative photoresist material and top exposure.

Although particular embodiments of the invention have hereinbefore been disclosed and described, the invention is nonetheless limited only by the following claims.

## Claims

1. A method of making a photonic crystal comprising the steps:
a) coating a substantially flat surface of a substrate with a thick photoresist layer, the photoresist layer being generally transparent to a pre-selected band of wavelengths, and having a dielectric constant, a light exposure threshold level, and a top surface parallel to the flat substrate surface;
b) directing onto the top surface of the photoresist layer, for a pre-selected time, a first interference pattern of parallel fringes which lie in the plane of the photoresist top surface, the fringes having a pre-selected intensity, width, and spacing, the pre-selected time and fringe intensity being chosen to provide an exposure which is less than the photoresist light exposure threshold level, the interference pattern being formed by a laser interferometer, the laser light having a wavelength for which the photoresist is at least partially transparent;
c) directing onto the top surface of the photoresist layer, for a pre-selected time, at least a second interference pattern of parallel fringes, the fringes having a pre-selected intensity, width, and spacing, the pre-selected time and fringe intensity being chosen to provide an exposure which is less than the photoresist light exposure threshold level, in which the interference pattern is formed by a laser interferometer, the laser light having a wavelength for which the photoresist is at least partially transparent, in which the fringes of the first interference pattern intersect the fringes of the at least second interference pattern, over at least a portion of the photoresist surface, to form a pre-selected angle included between the intersecting fringes, and in which the sum of the light exposures due to the first and at least second interference fringe patterns is greater than the exposure threshold of the photoresist;
d) developing the photoresist to remove those portions of the photoresist which received an exposure above the threshold level, to form a periodic array of symmetrical projections of photoresist material over the surface portion of intersection of the first and second interference patterns.

2. The method of claim 1 in which the aspect ratio of the projections is ≥ 3.

3. The method of claim 1 in which the fabrication step a) includes a photoresist application method selected from the group consisting of spin coating, dip coating, meniscus coating, and dry plasma coating.

4. The method of claim 1 in which the volume surrounding each of the photoresist projections is characterized by a first dielectric constant and the photoresist projections are characterized by a second dielectric constant and the second dielectric constant is at least a factor of 4 times the first dielectric constant.

5. The method of claim 1 in which two interference patterns are used and the fringe width and spacing of the first and second interference patterns are essentially equal and are selected to provide a period of the periodic array which lies in the range of 0.1 to 1.0 of the wavelengths of the band of wavelengths to which the photoresist is generally transparent.

6. The method of claim 5 in which of the band of wavelengths over which the photoresist is generally transparent is in the range of about 1300 nm to 1600 nm.

7. The method of claim 5 in which the included angle is close to 90°.

8. The method of claim 5 in which the first and second interference patterns are directed onto the photoresist sequentially.

9. The method of claim 5 in which the first and second interference patterns are directed simultaneously onto the photoresist.

10. The method of claim 1 in which the thickness of the photoresist coating is in the range of 3 Tm to 10 Tm.

11. The method of claim 1 in which three interference patterns are used and the fringe width and spacing of the first, second, and third interference patterns are essentially equal and the smaller included angle between any two intersecting fringes is 60°, to provide a hexagonal periodicity of photoresist projections after the development step.

12. A photonic crystal made using the method of claim 1.

13. A vertical stack of at least two photonic crystals made using the method of claim 1 in which the photoresist projections are vertically aligned.

14. A method of making a passive optical component in a photonic crystal comprising the steps:
a) depositing on a substrate a thin layer of material, the substrate having a flat surface and being at least partially transparent to light in a pre-selected band of wavelengths, the thin layer of coating material being essentially flat and covering the flat surface of the substrate and being opaque to light having a wavelength in said pre-selected band of wavelengths;
b) applying a thin coating of photoresist material on the thin layer of opaque material, the photoresist material being sensitive to light having a wavelength in said pre-selected band of wavelengths;
c) covering the photoresist material with a mask having respective portions transparent to and opaque to light having a wavelength in said pre-selected band of wavelengths, the opaque mask portion having a shape and size commensurate with a plan view cross section of a light guiding structure;
d) exposing the photoresist material to light of having a wavelength in said pre-selected band of wavelengths;
e) developing the photoresist material to remove the exposed portion of the photoresist material, leaving behind on the thin layer of opaque material a portion of photoresist material having the plan view cross section of a light guiding structure;
f) etching away the portion of the thin layer of opaque material made accessible in the developing step e), leaving on the substrate a thin opaque layer of material covered by a thin layer of photoresist material having the plan view cross section of a light guiding structure;
g) removing the thin photoresist layer, leaving on the substrate the thin opaque layer of material having the plan view cross section of a light guiding structure;
h) coating the substrate and thin opaque layer of material with a thick photoresist layer, the surface abutting the substrate and thin opaque layer of material being the backside of the thick photoresist layer;
i) directing through the substrate and onto the backside of the thick photoresist layer, for a pre-selected time, a first interference pattern of parallel fringes which lie in the plane of the thick photoresist backside surface, the fringes having a pre-selected intensity, width, and spacing, the pre-selected time and fringe intensity being chosen to provide an exposure which is less than the thick photoresist light exposure threshold level, the interference pattern being formed by a laser interferometer, the laser light having a wavelength for which the substrate and thick photoresist are at least partially transparent;
j) directing onto the backside surface of the thick photoresist layer, for a pre-selected time, at least a second interference pattern of parallel fringes, the fringes having a pre-selected intensity, width, and spacing, the pre-selected time and fringe intensity being chosen to provide an exposure which is less than the photoresist light exposure threshold level, in which the interference pattern is formed by a laser interferometer, the laser light having a wavelength for which the substrate and thick photoresist are at least partially transparent, in which the fringes of the first interference pattern intersect the fringes of the at least second interference pattern, over at least a portion of the photoresist surface, to form a pre-selected included angle, and in which the sum of the light exposures due to the first and at least second interference fringe patterns is greater than the exposure threshold of the thick photoresist;
k) developing the thick photoresist to remove those portions of the thick photoresist which received an exposure above the threshold level, leaving on the substrate a periodic array of symmetrical spaced generally cylindrical holes in the portion of the thick photoresist material which covers the substrate, the holes occurring at the intersections of the first and second set of fringes, and leaving on the thin opaque layer of material which blocked the exposure light a thick layer of photoresist material.

15. The method of claim 14 in which the thickness of the thin photoresist layer is ≤ 1.0 Tm.

16. The method of claim 14 in which the thickness of the thick photoresist layer is in the range 3 Tm to 10 Tm.

17. The method of claim 14 in which the respective steps b) and h) of applying or coating with a photoresist material includes an application method selected from the group consisting of spin coating, dip coating, meniscus coating, and dry plasma coating.

18. The method of claim 14 in which the thick photoresist is characterized by a first dielectric constant and the holes characterized by a second dielectric constant in which the first dielectric constant is at least a factor of 4 times the second dielectric.

19. The method of claim 14 in which the plan view cross section of the opaque portion of the mask in step c) has the shape and size of a waveguide structure having at least a first and a second end in which the at least first and second end each abut an area outside the photonic crystal.

20. The method of claim 19 in which the plan view cross section of the opaque portion of the mask in step c) has a first and a second side, the first and second sides being bounded by the photonic crystal and the shortest distance between the first and second side is in the range of 0.7 Tm to 20 Tm

21. The method of claim 19 in which the plan view cross section of the opaque portion of the mask in step c) is an N X M splitter or coupler, where N and M are integers greater than or equal to 1.

22. The method of claim 14 in which the plan view cross section of the opaque portion of the mask in step c) is an elongated segment having a length and a width and at least one generally circular opening, the segment width is greater than 1 hole diameter and less than or equal to 2 hole diameters, the length and width of the segment arranged to lie within the photonic crystal, the elongated dimension of the segment oriented along a row of holes of the photonic crystal.

23. The method of claim 14 in which the aspect ratio of the holes is ≥ 3.

24. The method of claim 14 in which two interference patterns are used and the fringe width and spacing of the first and second interference patterns are essentially equal and are selected to provide a period of the periodic array which lies in the range of 0.1 to 1.0 times the wavelengths of the band of wavelengths to which the photoresist is generally transparent.

25. The method of claim 24 in which of the band of wavelengths over which the photoresist is generally transparent is in the range of about 1300 nm to 1600 nm.

26. The method of claim 24 in which the included angle is close to 90°.

27. The method of claim 24 in which the first and second interference patterns are directed onto the photoresist sequentially.

28. The method of claim 24 in which the first and second interference patterns are directed simultaneously onto the photoresist.

29. The method of claim 14 in which three interference patterns are used and the fringe width and spacing of the first, second, and third interference patterns are essentially equal and the smaller included angle between any two intersecting fringes is 120°, to provide a hexagonal periodicity of photoresist projections after the development step.

30. A passive or active optical component in a photonic crystal made using the method of claim 14.

31. A vertical stack of at least two passive optical components in respective photonic crystals made using the method of claim 14 in which the photoresist projections are vertically aligned.
